# EUROPÄISCHE PATENTSCHRIFT

(11) **EP 2 917 782 B1**
(45) Veröffentlichungstag und Bekanntmachung des Hinweises auf die Patenterteilung: **20.11.2019**
(21) Anmeldenummer: 13774148.4
(22) Anmeldetag: 08.10.2013
(51) Int. Cl.: B23K 26/40, B32B 17/10, G02F 1/1343, G02F 1/17, G02F 1/155, H01L 51/52, H01L 51/00, B23K 26/57, B23K 26/53, B23K 101/38, B23K 103/16

(54) **MEHRSCHICHTFOLIE MIT ELEKTRISCH SCHALTBAREN OPTISCHEN EIGENSCHAFTEN**
MULTI-LAYER FILM WITH ELECTRICALLY SWITCHABLE OPTICAL PROPERTIES
FEUILLE MULTICOUCHE DOTÉE DE PROPRIÉTÉS OPTIQUES COMMUTABLES ÉLECTRIQUEMENT

(30) Priorität: 08.11.2012 EP 12191779
(43) Veröffentlichungstag der Anmeldung: 16.09.2015
(73) Patentinhaber: Saint-Gobain Glass France, 92400 Courbevoie (FR)
(72) Erfinder: BEHMKE, Michael, 40227 Düsseldorf (DE); LETOCART, Philippe, 4730 Raeren (BE); MENNIG, Julius, 60200 Compiègne (FR)
(74) Vertreter: Gebauer, Dieter Edmund
(86) Internationale Anmeldenummer: PCT/EP2013/070869
(87) Internationale Veröffentlichungsnummer: WO 2014/072137

(56) Entgegenhaltungen:
- WO-A1-2011/033313
- WO-A1-2012/007334
- US-A1- 2002 110 673
- US-A1- 2010 221 853
- US-A1- 2012 125 902
- US-A1- 2012 268 817

## Beschreibung

Die Erfindung betrifft eine Mehrschichtfolie mit elektrisch schaltbaren optischen Eigenschaften, ein Verfahren zu deren Herstellung und deren Verwendung.

Es sind Verglasungen mit elektrisch schaltbaren optischen Eigenschaften bekannt. Solche Verglasungen enthalten ein Funktionselement, welches typischerweise eine aktive Schicht zwischen zwei Flächenelektroden enthält. Die optischen Eigenschaften der aktiven Schicht können durch eine an die Flächenelektroden angelegte Spannung verändert werden. Ein Beispiel hierfür sind elektrochrome Funktionselemente, die beispielsweise aus US 20120026573 A1 und WO 2012007334 A1 bekannt sind. Ein weiteres Beispiel sind SPD-Funktionselemente (suspended particle device), die beispielsweise aus EP 0876608 B1 und WO 2011033313 A1 bekannt sind. Durch die angelegte Spannung lässt sich die Transmission von sichtbarem Licht durch elektrochrome oder SPD-Funktionselemente steuern. Verglasungen mit solchen Funktionselementen können also auf komfortable Weise elektrisch abgedunkelt werden.

Elektrisch schaltbare Funktionselemente werden häufig als Mehrschichtfolien bereitgestellt. Dabei ist das eigentliche Funktionselement zwischen zwei polymeren Trägerfolien angeordnet. Solche Mehrschichtfolien ermöglichen eine vereinfachte Herstellung einer elektrisch schaltbaren Verglasung. Typischerweise wird die Mehrschichtfolie zwischen zwei Glasscheiben mit herkömmlichen Methoden einlaminiert, wobei eine Verbundscheibe mit elektrisch schaltbaren optischen Eigenschaften erzeugt wird. Insbesondere können die Mehrschichtfolien kommerziell erworben werden, so dass der Hersteller der Verglasung das schaltbare Funktionselement an sich nicht eigens herstellen muss.

Es ist häufig erwünscht, dass die Flächenelektroden eines Funktionselements mit schaltbaren optischen Eigenschaften eine Strukturierung aufweisen. Eine solche Strukturierung ist insbesondere zumindest eine Unterbrechung der Flächenelektrode durch einen linienförmigen elektrisch nicht leitfähigen Bereich. So können beispielsweise Funktionselemente mit Teilbereichen realisiert werden, welche unabhängig voneinander schaltbar sind. Des Weiteren lassen sich damit örtlich begrenzte Teilbereiche des Funktionselements realisieren, die für elektromagnetische Strahlung transparent sind (sogenannte Kommunikationsfenster).

Soll eine Flächenelektrode einer Mehrschichtfolie mit einer Strukturierung versehen werden, so ist es möglich, die Flächenelektrode durch die Trägerfolie hindurch mechanisch zu zerschneiden. Dabei wird allerdings zwangsläufig die Trägerfolie beschädigt, was zu einem verringerten Schutz der Mehrschichtfolie gegen Korrosion führt. Außerdem kann auch die aktive Schicht beschädigt werden. Mechanisch eingebrachte Strukturierungslinien weisen zudem eine große Dicke auf, wodurch sie einem Betrachter optisch störend auffallen. Das mechanische Zerschneiden einer Flächenelektrode hat darüber hinaus häufig ein Umbiegen der Flächenelektrode entlang der Schnittkante in Richtung der aktiven Schicht und der gegenüberliegenden Flächenelektrode zur Folge, was zu Kurzschlüssen führen kann.

Die US-Patentanmeldung 2010/0221853 A1 zeigt eine Anordnung, bei der mittels Laser eine Struktur in eine Flächenelektrode eingebracht wird. Die Struktur erstreckt sich bis zum Rand der Flächenelektrode und ist elektrisch kontaktiert.

Eine Aufgabe der vorliegenden Erfindung ist es, eine gegenüber dem Stand der Technik verbesserte Mehrschichtfolie mit elektrisch schaltbaren optischen Eigenschaften bereitzustellen. Eine weitere Aufgabe der vorliegenden Erfindung ist es, ein verbessertes Verfahren zur Herstellung einer solchen Mehrschichtfolie mit elektrisch schaltbaren optischen Eigenschaften bereitzustellen. Das Verfahren soll das Strukturieren einer Flächenelektrode einer Mehrschichtfolie ermöglichen, wobei die Nachteile nach dem Stand der Technik vermieden werden.

Die Aufgabe der vorliegenden Erfindung wird erfindungsgemäß durch eine Mehrschichtfolie mit elektrisch schaltbaren optischen Eigenschaften gemäß dem Anspruch 1, durch ein Verfahren zur Herstellung der Mehrschichtfolie gemäß Anspruch 10 und durch eine Verwendung der Mehrschichtfolie gemäß Anspruch 15 gelöst. Weitere Ausgestaltungen der Erfindung werden in den abhängigen Ansprüchen definiert.

Die elektrisch nicht leifähige Linie ist in elektrisch leitfähige Schicht einer prälaminierten Mehrschichtfolie eingebracht. Das bedeutet, dass die elektrisch nicht leitfähige Linie erfindungsgemäß nach dem Verbinden der Trägerfolien, der elektrisch leitfähigen Schichten und der aktiven Schicht zur Mehrschichtfolie in die elektrisch leitfähige Schicht eingebracht ist.

In einer vorteilhaften Ausgestaltung ist die elektrisch nicht leitfähige Linie durch die benachbarte Trägerfolie hindurch in die elektrisch leitfähige Schicht eingebracht. Unter der benachbarten Trägerfolie ist im Sinne der Erfindung diejenige Trägerfolie zu verstehen, welche auf der von der aktiven Schicht abgewandten Seite derjenigen elektrisch leitfähigen Schicht, in welche die elektrisch nicht leitfähige Linie eingebracht ist, angeordnet ist. Die elektrisch leitfähige Schicht mit der elektrisch nicht leitfähigen Linie ist also zwischen der ihr benachbarten Trägerfolie und der aktiven Schicht angeordnet. Es ist jedoch grundsätzlich auch möglich, die elektrisch nicht leitfähige Linie in die elektrisch leitfähige Schicht durch die nicht benachbarte Trägerfolie hindurch (und durch die andere elektrisch leitfähige Schicht sowie die aktive Schicht hindurch) einzubringen.

Die Mehrschichtfolie ist ein Schichtstapel, wobei die Schichten des Schichtstapels zumindest eine erste Trägerfolie, eine erste elektrisch leitfähige Schicht, eine aktive Schicht, eine zweite elektrisch leitfähige Schicht und eine zweite Trägerfolie umfassen, welche in dieser Reihenfolge flächenmäßig übereinander angeordnet sind. Die Schichten des Schichtstapels sind dauerhaft stabil miteinander verbunden, beispielsweise durch Kleben oder Lamination. Die erste Trägerfolie ist die der ersten elektrisch leitfähigen Schicht benachbarte Trägerfolie. Die zweite Trägerfolie ist die der zweiten elektrisch leitfähigen Schicht benachbarte Trägerfolie.

Die Aufgabe der vorliegenden Erfindung wird weiter erfindungsgemäß durch ein Verfahren zur Herstellung einer erfindungsgemäßen Mehrschichtfolie mit elektrisch schaltbaren optischen Eigenschaften gelöst, wobei bei einer Mehrschichtfolie zumindest
A) die Strahlung eines Lasers durch eine Trägerfolie hindurch auf mindestens eine elektrisch leitfähige Schicht fokussiert wird und
B) die Strahlung des Lasers über die elektrisch leitfähige Schicht bewegt wird und dabei mindestens eine elektrisch nicht leitfähige Linie in die elektrisch leitfähige Schicht eingebracht wird.

Die einzelnen Schichten der Mehrschichtfolie werden miteinander zur fertigen Mehrschichtfolie verbunden, bevor das erfindungsgemäße Verfahren durchgeführt wird und die nicht leitfähige Linie dabei eingebracht wird. Die Mehrschichtfolie wird also als prälaminierte Mehrschichtfolie bereitgestellt.

Unter einer Mehrschichtfolie mit elektrisch schaltbaren optischen Eigenschaften wird im Sinne der Erfindung nicht nur eine Mehrschichtfolie bezeichnet, deren optische Eigenschaften, beispielsweise die Transmission von sichtbarem Licht, zwischen zwei diskreten Zuständen geschaltet werden können, beispielsweise einem opaken und einem transparenten Zustand. Es sind darunter auch solche Mehrschichtfolien zu verstehen, deren optische Eigenschaften stufenlos regelbar sind.

Unter einer elektrisch nicht leitfähigen Linie (oder Strukturierungslinie) ist im Sinne der Erfindung ein linienförmiger Bereich innerhalb der elektrisch leitfähigen Schicht zu verstehen, welcher nicht elektrisch leitfähig ist und welcher sich über die gesamte Dicke der elektrisch leitfähigen Schicht erstreckt. Die Linie wird erfindungsgemäß mittels eines Lasers in die elektrisch leitfähige Schicht eingebracht und durch laserinduzierte Degeneration innerhalb der elektrisch leitfähigen Schicht erzeugt. Eine solche laserinduzierte Degeneration ist beispielsweise die Abtragung der elektrisch leitfähigen Schicht oder eine chemische Veränderung der elektrisch leitfähigen Schicht. Durch die laserinduzierte Degeneration wird eine Unterbrechung der elektrischen Leitfähigkeit der Schicht erreicht.

Zumindest eine der elektrisch leitfähigen Schichten ist erfindungsgemäß mit mindestens einer elektrisch nicht leitfähigen Linie versehen. Die elektrisch leitfähige Schicht kann natürlich auch mehr als eine elektrisch nicht leitfähige Linie aufweisen. Es können auch beide elektrisch leitfähigen Schichten jeweils mindestens eine elektrisch nicht leitfähige Linie aufweisen.

Das eigentliche Funktionselement mit elektrisch schaltbaren optischen Eigenschaften wird durch die beiden elektrisch leitfähigen Schichten und die aktive Schicht gebildet. Die elektrisch leitfähigen Schichten bilden dabei Flächenelektroden. Durch Anlegen einer Spannung an die Flächenelektroden, beziehungsweise durch Änderung der an den Flächenelektroden anliegenden Spannung können die optischen Eigenschaften der aktiven Schicht, insbesondere die Transmission und/oder die Streuung von sichtbarem Licht beeinflusst werden.

In der erfindungsgemäßen Mehrschichtfolie ist das eigentliche Funktionselement zwischen zumindest zwei Trägerfolien angeordnet. Eine solche Mehrschichtfolie ist insbesondere dafür vorgesehen, mit mindestens einer Scheibe zu einer Verglasung mit elektrisch schaltbaren optischen Eigenschaften verbunden zu werden. Der Vorteil einer Mehrschichtfolie mit elektrisch schaltbaren optischen Eigenschaften liegt in einer einfachen Herstellung der Verglasung. Das eigentliche Funktionselement ist durch die Trägerfolien vorteilhaft vor Beschädigung, insbesondere Korrosion geschützt und kann vor der Herstellung der Verglasung auch in größerer Stückzahl bereitgestellt werden, was aus ökonomischen und verfahrenstechnischen Gründen wünschenswert sein kann. Ist die Verglasung eine Verbundscheibe, so kann die Mehrschichtfolie bei der Herstellung einfach in den Verbund eingelegt werden, welcher dann mit herkömmlichen Verfahren zur Verbundscheibe laminiert wird.

Der große Vorteil der Erfindung liegt in der Einbringung der elektrisch nicht leitfähigen Linien mittels Laserbearbeitung in eine vorher bereitgestellte Mehrschichtfolie. Der Hersteller der Verglasung kann die Mehrschichtfolie vor der Herstellung der Verglasung in großer Stückzahl herstellen oder auch kommerziell erwerben. Die elektrisch nicht leitfähigen Linien werden anschließend in Abhängigkeit von den Erfordernissen im Einzelfall eingebracht. Die Einbringung der elektrisch nicht leitfähigen Linien mittels Laserbearbeitung weist gegenüber einer mechanischen Bearbeitung eine Reihe von Vorteilen auf. Zum einen wird die elektrisch nicht leitfähige Linie selektiv in die elektrisch leitfähige Schicht eingebracht. Die Trägerfolie wird nicht beschädigt, so dass die aktiven Schicht und die elektrisch leitfähigen Schichten auch nach der Einbringung der elektrisch nicht leitfähigen Linie vor Korrosion und Alterung geschützt bleiben. Auch die Beschädigung der aktiven Schicht kann vermieden werden. Zum anderen wird ein Umbiegen der elektrisch leitfähigen Schicht entlang der Schnittkante in Richtung der aktiven Schicht und der anderen elektrisch leitfähigen Schicht, wie es beim mechanischen Zerschneiden der elektrisch leitfähigen Schicht auftreten kann, vermieden. Dadurch können Kurzschlüsse beim Betrieb der schaltbaren Mehrschichtfolie vermieden werden. Des Weiteren wird durch die Laserbearbeitung eine hohe Auflösung erreicht, wodurch dünnere Strukturierungslinien realisiert werden können als bei mechanischer Bearbeitung. Dünnere Linien sind für einen Betrachter weniger leicht sichtbar, was die Herstellung von ästhetischeren und optisch ansprechenderen Verglasungen ermöglicht.

Die erfindungsgemäße Mehrschichtfolie zeichnet sich gegenüber dem Stand der Technik insbesondere dadurch aus, dass die Trägerfolie, durch welche hindurch die elektrisch nicht leitfähigen Linie in die elektrisch leitfähige Schicht eingebracht ist (bevorzugt die der elektrisch leitfähigen Schicht benachbarte Trägerfolie) nicht beschädigt ist, also kein Unterbrechung aufweist, insbesondere keine Unterbrechung oberhalb der elektrisch nicht leifähigen Linie.

Die elektrisch leitfähigen Schichten sind dafür vorgesehen, mit zumindest einer externen Spannungsquelle auf an sich bekannte Art elektrisch verbunden zu werden, um als Flächenelektroden des schaltbaren Funktionselements zu dienen. Die elektrische Verbindung erfolgt durch geeignete Verbindungskabel, beispielsweise Folienleiter, welche optional über sogenannte Sammelleiter (bus bars), beispielsweise Streifen eines elektrisch leitfähigen Materials oder elektrisch leitfähige Aufdrucke, mit den elektrisch leitfähigen Schichten verbunden werden. Das Anbringen der Verbindungskabel an die elektrisch leitfähigen Schichten kann zeitlich vor oder nach dem Einbringen der erfindungsgemäßen elektrisch nicht leifähigen Linie erfolgen, beispielsweise durch Löten, Kleben oder Einlegen in die Mehrschichtfolie.

Die Trägerfolien enthalten bevorzugt zumindest ein thermoplastisches Polymer, besonders bevorzugt Polyethylenterephthalat (PET), Ethylenvinylacetat (EVA) und / oder Polyvinylbutyral (PVB), ganz besonders bevorzugt Polyethylenterephthalat (PET). Das ist besonders vorteilhaft im Hinblick auf die Stabilität der Mehrschichtfolie. Die Trägerfolien können aber auch beispielsweise Polypropylen, Polycarbonat, Polymethylmetacrylat, Polyacrylat, Polyvinylchlorid, Polyacetatharz, Acrylate, Fluorinierte Ethylen-Propylene, Polyvinylfluorid und / oder Ethylen-Tetrafluorethylen enthalten. Die Dicke jeder Trägerfolie beträgt bevorzugt von 0,1 mm bis 1 mm, besonders bevorzugt von 0,1 mm bis 0,2 mm. Durch Trägerfolien mit einer solchen geringen Dicke wird zum einen vorteilhaft eine geringe Dicke der Verglasung, in der die Mehrschichtfolie eingesetzt werden soll, erreicht. Zum anderen wird ein effektiver Schutz der aktiven Schicht und der elektrisch leitfähigen Schichten gewährleistet.

Die elektrisch leitfähigen Schichten sind bevorzugt transparent. Die elektrisch leitfähigen Schichten enthalten bevorzugt zumindest ein Metall, eine Metalllegierung oder ein transparentes leitfähiges Oxid (transparent conducting oxide, TCO). Die elektrisch leitfähigen Schichten enthalten bevorzugt zumindest ein transparentes leitfähiges Oxid. Es hat sich gezeigt, dass sich elektrisch leitfähige Schichten aus einem transparenten leitfähigen Oxid in besonderem Maße zur erfindungsgemäßen Laserbearbeitung eignen. Die elektrisch leitfähigen Schichten enthalten besonders bevorzugt zumindest Indium-Zinnoxid (ITO).

Die elektrisch leitfähigen Schichten können aber auch beispielsweise Silber, Gold, Kupfer, Nickel, Chrom, Wolfram, Indium-Zink-Oxid (IZO), Cadmiumstannat, Zinkstannat, Galliumdotiertes oder Aluminium-dotiertes Zinkoxid oder Fluor-dotiertes oder Antimon-dotiertes Zinnoxid enthalten.

Die elektrisch leitfähigen Schichten weisen bevorzugt eine Dicke von 10 nm bis 2 µm auf, besonders bevorzugt von 20 nm bis 1 µm, ganz besonders bevorzugt von 30 nm bis 500 nm und insbesondere von 50 nm bis 200 nm. Damit werden eine vorteilhafte elektrische Kontaktierung der aktiven Schicht und ein effektives Einbringen der erfindungsgemäßen elektrisch nicht leitfähigen Linie erreicht.

Das eigentliche schaltbare Funktionselement der erfindungsgemäßen Mehrschichtfolie kann prinzipiell jedes dem Fachmann an sich bekannte Funktionselement mit elektrisch schaltbaren optischen Eigenschaften sein. Die Ausgestaltung der aktiven Schicht richtet sich nach der Art des Funktionselements.

In einer vorteilhaften Ausgestaltung der Erfindung ist die Mehrschichtfolie ein elektrochromes Funktionselement. Dabei ist die aktive Schicht der Mehrschichtfolie eine elektrochemisch aktive Schicht. Die Transmission von sichtbarem Licht ist vom Einlagerungsgrad von Ionen in die aktive Schicht abhängig, wobei die Ionen beispielsweise durch eine Ionenspeicherschicht zwischen aktiver Schicht und einer Flächenelektrode bereitgestellt werden. Die Transmission kann durch die an die Flächenelektroden angelegte Spannung, welche eine Wanderung der Ionen hervorruft, beeinflusst werden. Geeignete aktive Schichten enthalten beispielsweise zumindest Wolframoxid oder Vanadiumoxid. Elektrochrome Funktionselemente sind beispielsweise aus WO 2012007334 A1, US 20120026573 A1, WO 2010147494 A1 und EP 1862849 A1 bekannt.

In einer weiteren vorteilhaften Ausgestaltung der Erfindung ist die Mehrschichtfolie ein PDLC-Funktionselement (Polymer dispersed liquid crystal). Dabei enthält die aktive Schicht Flüssigkristalle, welche beispielsweise in eine Polymermatrix eingelagert sind. Wird an die Flächenelektroden keine Spannung angelegt, so sind die Flüssigkristalle ungeordnet ausgerichtet, was zu einer starken Streuung des durch die aktive Schicht tretenden Lichts führt. Wird an die Flächenelektroden eine Spannung angelegt, so richten sich die Flüssigkristalle in einer gemeinsamen Richtung aus und die Transmission von Licht durch die aktive Schicht wird erhöht. Ein solches Funktionselement ist beispielsweise aus DE 102008026339 A1 bekannt.

In einer weiteren vorteilhaften Ausgestaltung der Erfindung ist die Mehrschichtfolie ein elektrolumineszentes Funktionselement. Dabei enthält die aktive Schicht elektrolumineszente Materialen, welche anorganisch oder organisch (OLED) sein können. Durch Anlegen einer Spannung an die Flächenelektroden wird die Lumineszenz der aktiven Schicht angeregt. Solche Funktionselemente sind beispielsweise aus US 2004227462 A1 und WO 2010112789 A2 bekannt.

In einer weiteren vorteilhaften Ausgestaltung der Erfindung ist die Mehrschichtfolie ein SPD-Funktionselement (suspended particle device). Dabei enthält die aktive Schicht suspendierte Partikel, welche bevorzugt in eine zähflüssige Matrix eingelagert sind. Die Absorption von Licht durch die aktive Schicht ist durch das Anlegen einer Spannung an die Flächenelektroden veränderbar, welche zu einer Orientierungsänderung der suspendierten Partikel führt. Solche Funktionselemente sind beispielsweise aus EP 0876608 B1 und WO 2011033313 A1 bekannt.

Die Mehrschichtfolie kann natürlich außer der aktiven Schicht, den elektrisch leitfähigen Schichten und den Trägerfolien weitere an sich bekannte Schichten aufweisen, beispielsweise Barriereschichten, Blockerschichten, Antireflexions- oder Reflexionsschichten, Schutzschichten und / oder Glättungsschichten.

Die Fläche der erfindungsgemäßen Mehrschichtfolie kann breit variieren und so den Erfordernissen im Einzelfall angepasst werden. Die Fläche beträgt beispielsweise von 100 cm² bis 20 m². Bevorzugt weist die Mehrschichtfolie eine Fläche von 400 cm² bis 6 m² auf, wie sie für die Herstellung von Verglasungen von Fahrzeugen und von Bau- und Architekturverglasungen üblich sind.

Die Linienbreite der erfindungsgemäßen elektrisch nicht leifähigen Linie kann beispielsweise kleiner oder gleich 500 µm betragen. In einer bevorzugten Ausgestaltung der Erfindung beträgt die Linienbreite von 10 µm bis 150 µm, besonders bevorzugt von 20 µm bis 50 µm, beispielsweise von 30 µm bis 40 µm. In diesem Bereich für die Linienbreite werden besonders gute Ergebnisse erzielt. Einerseits ist die elektrisch nicht leitfähige Linie breit genug, um zu einer effektiven Unterbrechung der elektrisch leitfähigen Schicht zu führen.

Andererseits ist die Linienbreite vorteilhaft gering, um für einen Betrachter nur wenig sichtbar zu sein. Strukturierungslinien mit diesen geringen Linienbreiten sind mit mechanischen Bearbeitungsverfahren nur schwer oder überhaupt nicht realisierbar. Die Linienbreite kann im erfindungsgemäßen Verfahren insbesondere durch die Ausdehnung des Fokus der Laserstrahlung sowie durch die Leistung der Laserstrahlung eingestellt werden.

Bei der Erfindung wird die elektrisch leitfähige Schicht durch die mindestens eine elektrisch nicht leitfähige Linie in mindestens zwei Teilbereiche aufgeteilt, welche nicht elektrisch leitend miteinander verbunden sind. Das wird erreicht, indem die Linie als geschlossene Form ohne Enden ausgestaltet ist. Auf diese Weise kann mindestens ein Teilbereich der elektrisch leitfähigen Schicht von der übrigen, als Flächenelektrode dienenden Schicht elektrisch isoliert werden. Der isolierte Teilbereich ist selbst nicht dafür vorgesehen, elektrisch kontaktiert und mit einer externen Spannungsquelle verbunden zu werden, so dass er nicht als Flächenelektrode dient. Durch den isolierten Teilbereich der elektrisch leitfähigen Schicht wird also bei einer Änderung der an die Flächenelektroden angelegten Spannung kein Schaltvorgang der optischen Eigenschaften der aktiven Schicht ausgelöst. Ein solcher isolierter Teilbereich der elektrisch leitfähigen Schicht kann beispielsweise als geometrische Figur, Piktogramm, Buchstabe, Zahl oder Symbol ausgestaltet sein. Die Mehrschichtfolie ist also im Bereich des isolierten Teilbereichs der elektrisch leitfähigen Schicht nicht von einer Schaltung der optischen Eigenschaften betroffen. Die durch den isolierten Teilbereich gebildete Form wird somit auf ästhetisch ansprechende Weise sichtbar gemacht.

In einer weiteren Ausgestaltung der Erfindung wird die elektrisch leitfähige Schicht durch die mindestens eine elektrisch nicht leitfähige Linie in mindestens zwei Teilbereiche aufgeteilt, welche nicht elektrisch leitend miteinander verbunden sind. Jeder Teilbereich ist dafür vorgesehen, mit einer von mindestens zwei unabhängigen Spannungsquellen verbunden zu werden. Jeder Teilbereich dient somit als Flächenelektrode. Auf diese Weise kann eine Mehrschichtfolie mit Teilbereichen realisiert werden, deren optische Eigenschaften unabhängig voneinander geschaltet werden können. Mindestens ein Teilbereich der elektrisch leitfähigen Schicht kann beispielsweise als geometrische Figur, Piktogramm, Buchstabe, Zahl oder Symbol ausgestaltet sein und mit einer anderen Spannungsquelle verbunden werden als der ihn umgebende Teilbereich der elektrisch leitfähigen Schicht. Durch geeignete Wahl der Schaltzustände kann die geometrische Figur, das Piktogramm, der Buchstabe, die Zahl oder das Symbol auf ästhetisch ansprechende Weise sichtbar gemacht werden. Es können auch Mehrschichtfolien mit großflächigen, unabhängig voneinander schaltbaren Bereichen realisiert werden. Mit einer solchen Mehrschichtfolie können beispielsweise Dachscheiben eines Kraftfahrzeugs hergestellt werden, deren optische Eigenschaften im Bereich des Fahrers und im Bereich der Rückbank unterschiedlich geschaltet werden können oder bei denen sogar ein Verlauf der optischen Eigenschaften, insbesondere der Transmission von sichtbarem Licht, durch eine Vielzahl von unabhängig schaltbaren Bereichen eingestellt werden kann. Eine weitere beispielhafte Anwendungsmöglichkeit ist die Herstellung von großflächigen Verglasungen eines Großraumbüros, wobei die optischen Eigenschaften im Bereich der verschiedenen Arbeitsplätze unabhängig voneinander schaltbar sind.

Wird eine der beiden erfindungsgemäßen elektrisch leitfähigen Schichten durch die mindestens eine elektrisch nicht leitfähige Linie in mindestens zwei elektrisch nicht miteinander verbundene Teilbereiche aufgeteilt, welche zur Unterteilung der Flächenelektrode dienen, so weist die anderer der beiden erfindungsgemäßen elektrisch leitfähigen Schichten bevorzugt keine elektrisch nicht leitfähige Linie auf. Das ist besonders vorteilhaft im Hinblick auf eine einfache Herstellung der erfindungsgemäßen Mehrschichtfolie. Die Linienbreite der elektrisch nicht leitfähigen Linie beträgt dabei bevorzugt von 10 µm bis 150 µm, besonders bevorzugt von 20 µm bis 50 µm. Es war für den Fachmann unerwartet und überraschend, dass durch eine Strukturierungslinie mit einer solchen geringen Breite in nur einer der elektrisch leitfähigen Schichten Teilbereiche in der Mehrschichtfolie ausgebildet werden können, deren optische Eigenschaften unabhängig voneinander schaltbar sind.

Alternativ können aber auch beide elektrisch leitfähigen Schichten zumindest eine elektrisch nicht leitfähige Linie aufweisen. Die beiden elektrisch leitfähigen Schichten können dadurch beispielsweise in deckungsgleiche Teilbereiche unterteilt werden. Die Teilbereiche der elektrisch leitfähigen Schichten können sich aber auch in Form und/oder Position unterscheiden. Insbesondere können die elektrisch leitfähigen Schichten Teilbereiche in Form unterschiedlicher Figuren, Symbole oder Piktogramme aufweisen, welche bei Durchsicht durch die Mehrschichtfolie etwa übereinander angeordnet sind. Durch geeignete Wahl der Schaltzustände können so Mehrschichtfolien realisiert werden, bei denen an der gleichen Stelle in Abhängigkeit vom Schaltzustand jeweils eins von zwei unterschiedlichen Symbolen erscheint.

In einer weiteren Ausgestaltung der Erfindung kann durch die zumindest eine elektrisch nicht leifähige Linie ein sogenanntes Kommunikationsfenster oder Datenübertragungsfenster ausgebildet werden. Die elektrisch leitfähigen Schichten sind typischerweise für elektromagnetische Strahlung im Infrarot-, Mikrowellen- und Radiobereich nicht transparent. Durch die elektrisch nicht leifähige Linie können ein oder mehrere Bereiche erzeugt werden, welche für die elektromagnetische Strahlung transparent sind. Dies ist häufig erwünscht, um die Transmission von beispielsweise GPS-, Radio oder Telekommunikationssignalen durch eine mit der Mehrschichtfolie versehene Verglasung zu gewährleisten. Durch die erfindungsgemäße elektrisch nicht leifähige Linie wird dazu zumindest eine lokale Unterbrechung in die elektrisch leitfähige Schicht eingebracht. Bevorzugt weisen beide elektrisch leitfähigen Schichten zumindest eine elektrisch nicht leifähige Linie auf, wobei die Linien der beiden elektrisch leitfähigen Schichten zumindest teilweise deckungsgleich (also in Deckung zueinander) angeordnet sind. Das bedeutet, dass die Strukturierungslinie der ersten elektrisch leitfähigen Schicht zumindest einen Abschnitt aufweist, der mit zumindest einem Abschnitt der Strukturierungslinie der zweiten elektrisch leitfähigen Schicht bei Durchsicht durch die Mehrschichtfolie deckungsgleich ausgebildet und angeordnet ist. Die Abschnitte sind dann deckungsgleich, wenn die Orthogonalprojektion des Abschnitts der Strukturierungslinie der ersten elektrisch leitfähigen Schicht auf die zweite elektrisch leitfähige Schicht die Fläche des Abschnitts der Strukturierungslinie der zweiten elektrisch leitfähigen Schicht bildet. Durch zumindest teilweise deckungsgleiche, bevorzugt deckungsgleiche elektrisch nicht leitfähige Linien in den beiden elektrisch leitfähigen Schichten wird die gesamte Mehrschichtfolie vorteilhaft in einem Bereich transparent für elektromagnetische Strahlung zur Datenübertragung. Die elektrisch nicht leitfähigen Linien können beispielsweise als gerade Linien, Kreuze oder Gitter ausgestaltet sein.

Soll in beide elektrisch leitfähige Schichten jeweils zumindest eine elektrisch nicht leitfähige Linie eingebracht werden, wobei die Linien deckungsgleich ausgebildet sind, so können die Linie der beiden elektrisch leitfähigen Schichten zeitlich nacheinander eingebracht werden. Es ist ein besonderer Vorteil des erfindungsgemäßen Verfahrens, dass die Strukturierungslinien mit der dazu nötigen hohen Präzision und Reproduzierbarkeit in die elektrisch leitfähigen Schichten eingebracht werden können. Wird das erfindungsgemäße Verfahren auf eine Mehrschichtfolie mit geeigneter aktiver Schicht angewendet, insbesondere mit einer aktiven Schicht mit einem ausreichend geringen Absorptionsgrad gegenüber der Wellenlänge der Laserstrahlung, so können alternativ beide elektrisch leitfähige Schichten vom Fokus der Laserstrahlung erfasst werden und die Strukturierungslinien zeitgleich eingebracht werden.

Natürlich sind auch Kombinationen der beschriebenen Ausgestaltungen in einem einzigen laminierten Funktionselement möglich.

Die elektrisch nicht leitfähige Linie wird erfindungsgemäß mittels eines Lasers in die elektrisch leitfähige Schicht eingebracht. Die Strahlung des Lasers tritt durch eine Trägerfolie hindurch in die Mehrschichtfolie ein. Die Strahlung des Lasers wird bevorzugt mittels zumindest eines optischen Elements, beispielsweise einer Linse oder eines Objektivs auf die elektrisch leitfähige Schicht fokussiert. Besonders geeignet sind f-theta-Linsen oder f-theta-Objektive. Diese führen dazu, dass die Foki der Laserstrahlung bei unterschiedlichen Austrittswinkeln in einer Ebene angeordnet sind und ermöglichen eine konstante Bewegungsgeschwindigkeit der Laserstrahlung über die elektrisch leitfähige Schicht.

Die Brennweite des fokussierenden Elements bestimmt die Ausdehnung des Fokus der Laserstrahlung. Die Brennweite des fokussierenden optischen Elementes beträgt bevorzugt von 5 cm bis 100 cm, besonders bevorzugt von 10 cm bis 40 cm. Damit werden besonders gute Ergebnisse erzielt. Eine kleinere Brennweite des optischen Elements erfordert einen zu geringen Arbeitsabstand zwischen elektrisch leitfähiger Schicht und optischem Element. Eine größere Brennweite führt zu einer zu großen Ausdehnung des Laserfokus, wodurch das Auflösungsvermögen des Strukturierungsverfahrens und die Leistungsdichte im Fokus beschränkt werden.

Zwischen dem Laser und dem fokussierenden optischen Element kann die Strahlung des Lasers durch zumindest einen Lichtwellenleiter, beispielsweise eine Glasfaser geleitet werden. Es können auch weitere optische Elemente im Strahlengang des Lasers angeordnet sein, beispielsweise Kollimatoren, Blenden, Filter oder Elemente zur Frequenzverdopplung.

Die elektrisch nicht leitfähige Linie wird durch eine Bewegung der Strahlung des Lasers relativ zur Mehrschichtfolie in die elektrisch leitfähige Schicht eingebracht. In einer vorteilhaften Ausführung ist die Mehrschichtfolie während des Einbringens der Linie ortsfest und die Strahlung des Lasers wird über die elektrisch leitfähige Schicht bewegt. Die Bewegung der Strahlung des Lasers erfolgt bevorzugt durch zumindest einen Spiegel, der mit einem bewegbaren Bauteil verbunden ist. Durch das bewegbare Bauteil kann der Spiegel in zwei Richtungen, bevorzugt zwei zueinander orthogonalen Richtungen, besonders bevorzugt horizontal und vertikal, verkippt werden. Die Bewegung der Strahlung des Lasers kann auch durch mehrere mit jeweils einem bewegbaren Bauteil verbundene Spiegel erfolgen. Beispielsweise kann die Bewegung der Strahlung des Lasers durch zwei Spiegel erfolgen, wobei ein Spiegel in horizontaler Richtung und der andere Spiegel in vertikaler Richtung verkippt werden kann.

Alternativ kann die Bewegung der Strahlung des Lasers durch eine Bewegung des fokussierenden Elements und des Lasers oder durch eine Bewegung des fokussierenden Elements und eines Lichtwellenleiters über die ortsfeste Mehrschichtfolie erfolgen. Alternativ kann die Strahlung des Lasers ortsfest sein und die Mehrschichtfolie zum Einbringen der elektrisch nicht leitfähigen Linie bewegt werden.

Die Strahlung des Lasers wird bevorzugt mit einer Geschwindigkeit von 100 mm/s bis 10000 mm/s, besonders bevorzugt von 200 mm/s bis 5000 mm/s, ganz besonders bevorzugt von 300 mm/s bis 2000 mm/s über die elektrisch leitfähige Schicht bewegt, beispielsweise von 500 mm/s bis 1000 mm/s. Damit werden besonders gute Ergebnisse erzielt.

Die Wellenlänge der Laserstrahlung, mit der die elektrisch leitfähige Linie in die elektrisch leitfähige Schicht eingebracht wird, ist geeignet so zu wählen, dass die elektrisch leitfähige Schicht eine ausreichend hohe Absorption der Laserstrahlung aufweist und dass die Trägerfolie eine ausreichend geringe Absorption der Laserstrahlung aufweist. Dadurch wird die Linie vorteilhaft selektiv in die elektrisch leitfähige Schicht eingebracht, ohne dass die Trägerfolie beschädigt wird. Dabei ist zu berücksichtigen, dass durch die Fokussierung der Laserstrahlung die Leistungsdichte in der elektrisch leitfähigen Schicht deutlich größer ist als in der Trägerschicht.

Der Absorptionsgrad der elektrisch leitfähigen Schicht, in welche die elektrisch nicht leitfähige Linie eingebracht werden soll, gegenüber der Laserstrahlung beträgt bevorzugt größer oder gleich 0,1%, besonders bevorzugt größer oder gleich 0,3%, beispielsweise von 0,3% bis 20%. Der Absorptionsgrad der elektrisch leitfähigen Schicht gegenüber der Laserstrahlung beträgt ganz besonders bevorzugt größer oder gleich 5%, und insbesondere größer oder gleich 10%. Der Absorptionsgrad der Trägerfolie, durch welche hindurch die Laserstrahlung auf die elektrisch leitfähige Schicht fokussiert wird, gegenüber der Laserstrahlung beträgt bevorzugt kleiner oder gleich 15%, besonders bevorzugt kleiner oder gleich 10%, ganz besonders bevorzugt kleiner oder gleich 7%.

Das Verhältnis der Absorption der elektrisch leitfähigen Schicht zur Absorption der Trägerschicht bei der Wellenlänge der Laserstrahlung beträgt in einer besonders vorteilhaften Ausführung größer oder gleich 0,5, besonders bevorzugt größer oder gleich 1, ganz besonders bevorzugt größer oder gleich 1,5 und insbesondere größer oder gleich 2. Damit wird eine vorteilhaft selektive Einbringung der elektrisch nicht leitfähigen Linie in die elektrisch leitfähige Schicht erreicht.

In einer bevorzugten Ausführung beträgt die Wellenlänge der Laserstrahlung, mit der die elektrisch nicht leitfähige Linie in die elektrisch leitfähige Schicht eingebracht wird, von 150 nm bis 1200 nm, besonders bevorzugt von 200 nm bis 500 nm, ganz besonders bevorzugt von 250 nm bis 400 nm. Es hat sich gezeigt, dass dieser Bereich für die Wellenlänge bei der Verwendung üblicher elektrisch leitfähiger Schichten und üblicher Trägerfolien besonders geeignet ist, um die Linie selektiv in die elektrisch leitfähige Schicht einzubringen.

Als Laser wird bevorzugt ein Festkörper-Laser verwendet, beispielsweise ein Nd:Cr:YAG-Laser, ein Nd:Ce:YAG-Laser, ein Yb:YAG-Laser, besonders bevorzugt ein Nd:YAG-Laser. Die Strahlung des Lasers kann zur Erzeugung der gewünschten Wellenlänge einfach oder mehrfach frequenzverdoppelt werden. Es können aber auch andere Laser verwendet werden, beispielsweise Faserlaser, Halbleiterlaser, Excimerlaser oder Gaslaser.

Der Laser wird bevorzugt gepulst betrieben. Das ist besonders vorteilhaft im Hinblick auf eine hohe Leistungsdichte und eine effektive Einbringung der elektrisch nicht leitfähigen Linie. Die Pulsfrequenz beträgt bevorzugt von 1 kHz bis 200 kHz, besonders bevorzugt von 10 kHz bis 100 kHz, beispielsweise von 30 kHz bis 60 kHz. Die Pulslänge beträgt bevorzugt kleiner oder gleich 50 ns. Das ist besonders vorteilhaft im Hinblick auf die Leistungsdichte des Lasers bei der Laserstrukturierung.

Die Ausgangsleistung der Strahlung des Lasers beträgt bevorzugt von 0,1 W bis 50 W, beispielsweise von 0,3 W bis 10 W. Die benötigte Ausgangsleistung ist insbesondere abhängig von der verwendeten Wellenlänge der Laserstrahlung sowie dem Absorptionsgrad der elektrisch leitfähigen Schicht und kann vom Fachmann durch einfache Versuche ermittelt werden. Es hat sich gezeigt, dass die Leistung der Laserstrahlung die Linienbreite der elektrisch nicht leitfähigen Linie beeinflusst, wobei eine höhere Leistung zu einer größeren Linienbreite führt.

Die Erfindung umfasst weiter eine Verbundscheibe, wobei mindestens eine erfindungsgemäße Mehrschichtfolie zwischen mindestens zwei Scheiben flächenmäßig angeordnet ist. Die Mehrschichtfolie ist bevorzugt in die Zwischenschicht der Verbundscheibe eingelagert. Dazu ist jede Trägerfolie bevorzugt über mindestens eine thermoplastische Verbindungsfolie mit jeweils einer Scheibe verbunden. Die Verbindung erfolgt unter Einwirkung von Hitze, Vakuum und / oder Druck nach an sich bekannten Verfahren. Die thermoplastischen Verbindungsfolien enthalten zumindest ein thermoplastisches Polymer, beispielsweise Ethylenvinylacetat, Polyvinylbutyral, Polyurethan und/oder Polyethylenterephthalat. Die Dicke der thermoplastischen Verbindungsfolien beträgt bevorzugt von 0,25 mm bis 2 mm, beispielsweise 0,38 mm oder 0,76 mm. Die Scheiben enthalten bevorzugt Glas, besonders bevorzugt Flachglas, Floatglas, Quarzglas, Borosilikatglas, Kalk-Natron-Glas oder klare Kunststoffe, besonders bevorzugt starre klare Kunststoffe, beispielsweise Polycarbonat oder Polymethylmethacrylat. Die Scheiben können klar und transparent sein oder auch getönt oder gefärbt. Die Dicke der Scheiben kann breit variieren und so den Erfordernissen im Einzelfall angepasst werden. Die Dicke jeder Scheibe beträgt bevorzugt von 0,5 mm bis 15 mm, besonders bevorzugt von 1 mm bis 5 mm. Die Verbundscheibe kann eine beliebige dreidimensionale Form aufweisen. Die Verbundscheibe ist bevorzugt plan oder leicht oder stark in einer Richtung oder in mehreren Richtungen des Raumes gebogen.

Die Erfindung umfasst eine Verbundscheibe, die mit dem erfindungsgemäßen Verfahren erhältlich ist.

Die erfindungsgemäße Mehrschichtfolie mit elektrisch schaltbaren optischen Eigenschaften wird bevorzugt in Verglasungen, insbesondere in Verbundscheiben, in Gebäuden, insbesondere im Zugangs- oder Fensterbereich, oder in Fortbewegungsmitteln für den Verkehr auf dem Lande, in der Luft oder zu Wasser, insbesondere in Zügen, Schiffen, Flugzeugen und Kraftfahrzeugen, beispielsweise als Heckscheibe, Seitenscheibe und / oder Dachscheibe verwendet.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
- Fig. 1: einen Querschnitt durch eine Mehrschichtfolie mit elektrisch schaltbaren optischen Eigenschaften während des erfindungsgemäßen Verfahrens,
- Fig. 2: eine Draufsicht auf eine erste Ausgestaltung der erfindungsgemäßen Mehrschichtfolie mit elektrisch schaltbaren optischen Eigenschaften,
- Fig. 3: einen Querschnitt entlang A-A' durch die Mehrschichtfolie aus Fig. 2,
- Fig. 4: eine Draufsicht auf eine weitere Ausgestaltung der erfindungsgemäßen Mehrschichtfolie mit elektrisch schaltbaren optischen Eigenschaften,
- Fig. 5: eine Draufsicht auf eine weitere Ausgestaltung der erfindungsgemäßen Mehrschichtfolie mit elektrisch schaltbaren optischen Eigenschaften,
- Fig. 6: einen Querschnitt entlang B-B' durch die Mehrschichtfolie aus Fig. 5,
- Fig. 7: die Mehrschichtfolie aus Fig. 2 eingelagert in der Zwischenschicht einer Verbundscheibe und
- Fig. 8: ein Ausführungsbeispiel des erfindungsgemäßen Verfahrens anhand eines Flussdiagramms.

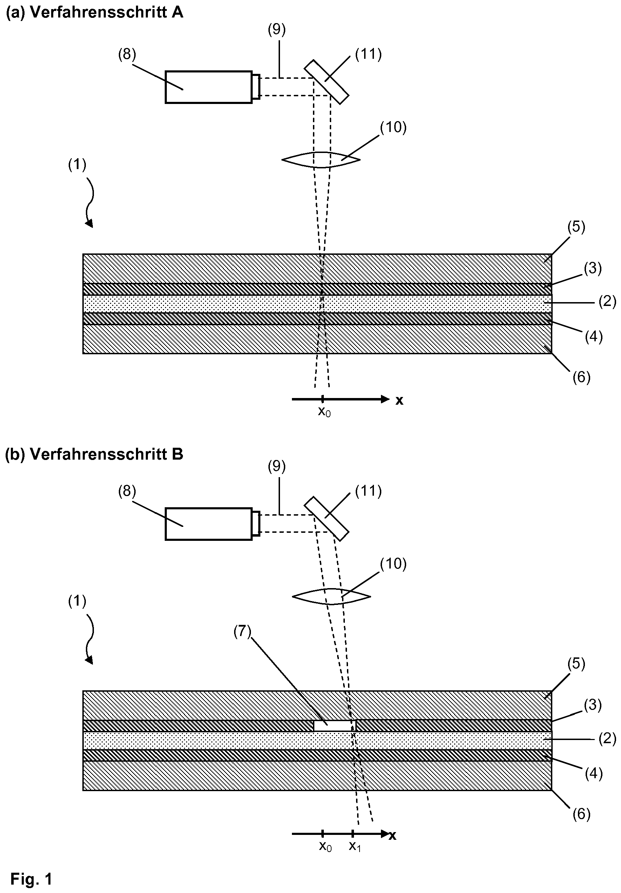

Fig. 1 zeigt einen Querschnitt durch eine Mehrschichtfolie 1 mit elektrisch schaltbaren optischen Eigenschaften während des erfindungsgemäßen Verfahrens. Die Mehrschichtfolie 1 ist ein SPD-Funktionselement. Die Mehrschichtfolie 1 umfasst eine erste Trägerfolie 5, eine erste elektrisch leitfähige Schicht 3, eine aktive Schicht 2, eine zweite elektrisch leitfähige Schicht 4 und eine zweite Trägerfolie 6, welche in der angegebenen Reihenfolge flächenmäßig übereinander angeordnet sind. Die Trägerfolien 5, 6 bestehen aus Polyethylenterephthalat (PET) und weisen eine Dicke von 0,125 mm auf. Die elektrisch leitfähigen Schichten 3, 4 bestehen aus Indium-Zinnoxid (ITO) und weisen eine Dicke von beispielsweise etwa 50 nm auf. Die aktive Schicht 2 enthält polarisierte Partikel suspendiert in einem Harz. In Abhängigkeit von einer an die elektrisch leitfähigen Schichten 3, 4 angelegten Spannung richten sich die suspendierten Partikel entlang einer gemeinsamen Raumrichtung aus. Durch die Ausrichtung der Partikel wird die Absorption von sichtbarem Licht herabgesetzt. Die Transmission von sichtbarem Licht durch die Mehrschichtfolie 1 kann daher komfortabel elektrisch gesteuert werden.

Mit dem erfindungsgemäßen Verfahren wird mindestens eine elektrisch nicht leitfähige Linie 7 in die elektrisch leitfähige Schicht 3 der Mehrschichtfolie 1 eingebracht. Fig. 1a zeigt die Mehrschichtfolie 1 während des ersten Verfahrensschritts. Die Strahlung 9 eines Lasers 8 wird mittels einer f-theta-Linse als fokussierendes Element 10 durch die Trägerfolie 5 hindurch an der Position x₀ auf die elektrisch leitfähige Schicht 3 fokussiert. Mittels eines beweglichen Spiegels 11 kann die Strahlung 9 entlang der Richtung x über die elektrisch leitfähige Schicht 3 bewegt werden. Die Bewegung der Strahlung 9 führt zu einer laserinduzierten Degeneration der elektrisch leitfähigen Schicht 3. Fig. 1b zeigt die Mehrschichtfolie 1 während des zweiten Verfahrensschritts. Die Strahlung 9 ist von der Position x₀ zur Position x₁ bewegt worden. Dadurch ist zwischen den Positionen x₀ und x₁ eine elektrisch nicht leitfähige Linie 7 innerhalb der elektrisch leitfähigen Schicht 3 entstanden. Die Linie 7 ist ein elektrisch nicht leitfähiger, linienförmiger Bereich innerhalb der ersten elektrisch leitfähigen Schicht 3, welcher sich über die gesamte Dicke der ersten elektrisch leitfähigen Schicht 3 erstreckt und dessen Verlauf von der Bewegungsrichtung x abhängt. Die Linie 7 ist dabei vorteilhaft selektiv in die elektrisch leitfähige Schicht 3 eingebracht. Insbesondere wird die Trägerfolie 5 beim Einbringen der Linie 7 nicht beschädigt.

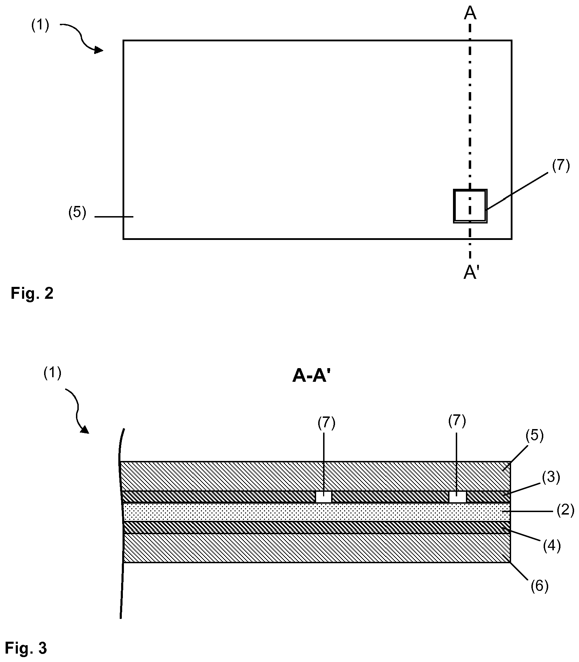

Fig. 2 und Fig. 3 zeigen je ein Detail einer Ausgestaltung der erfindungsgemäßen Mehrschichtfolie 1 mit elektrisch schaltbaren optischen Eigenschaften. In die elektrisch leitfähige Schicht 3 ist erfindungsgemäß eine elektrisch nicht leitfähige Linie 7 eingebracht. Die elektrisch leitfähige Schicht 3 wird durch die Linie 7 in zwei Teilbereiche aufgeteilt, welche nicht elektrisch leitend miteinander verbunden sind. Die Linie 7 ist dazu als geschlossene Form ausgestaltet, welche der Einfachheit halber als Quadrat dargestellt ist. Der Teilbereich der elektrisch leitfähigen Schicht 3 innerhalb der durch die Linie 7 gebildeten geschlossenen Form ist von der übrigen elektrisch leitfähigen Schicht 3 elektrisch isoliert.

Soll die Mehrschichtfolie 1 innerhalb einer Verglasung verwendet werden, so können die elektrisch leitfähigen Schichten 3, 4 beispielsweise über Folienleiter und weitere geeignete Verbindungskabel mit einer externen Spannungsquelle verbunden werden. Die Verbindung mit dem Folienleiter erfolgt dabei bevorzugt im Randbereich der elektrisch leitfähigen Schichten 3,4. In Abhängigkeit der angelegten Spannung können die optischen Eigenschaften der aktiven Schicht 2 verändert werden. Der durch die Linie 7 isolierte Teilbereich der elektrisch leitfähigen Schicht 3 bewirkt dabei keine Änderung der optischen Eigenschaften. Die von der Linie 7 umgebene Form, welche in der Realität beispielsweise als Firmensymbol ausgebildet sein kann, wird dadurch sichtbar gemacht.

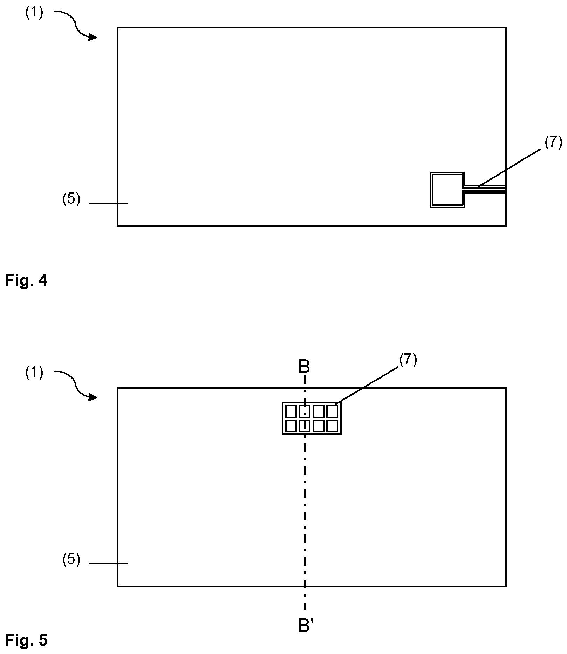

Fig. 4 zeigt eine Draufsicht auf eine weitere Ausgestaltung der erfindungsgemäßen Mehrschichtfolie 1 mit elektrisch schaltbaren optischen Eigenschaften. In die elektrisch leitfähige Schicht 3 ist erfindungsgemäß eine elektrisch nicht leitfähige Linie 7 eingebracht. Die elektrisch leitfähige Schicht 3 wird durch die Linie 7 in zwei Teilbereiche aufgeteilt, welche nicht elektrisch leitend miteinander verbunden sind. Die beiden Enden der Linie 7 sind dazu an einer Seitenkante der elektrisch leitfähigen Schicht 3 angeordnet.

Da sich beide elektrisch voneinander isolierten Teilbereiche der elektrisch leitfähigen Schicht 3 bis zu zumindest einer Seitenkante der elektrisch leitfähigen Schicht 3 erstrecken, können die beiden Teilbereiche einfach und optisch unauffällig beispielsweise über jeweils einen Folienleiter mit zwei voneinander unabhängigen Spannungsquellen verbunden werden. Durch die beiden Teilbereiche der elektrisch leitfähigen Schicht 3 können also verschiedene Schaltzustände der optischen Eigenschaften der aktiven Schicht 2 hervorgerufen werden.

Wird die Mehrschichtfolie 1 innerhalb einer Verglasung verwendet, so weist diese Verglasung also zwei unabhängig voneinander schaltbare Teilbereiche auf. Die Linie 7 kann in der Realität beispielsweise als Firmensymbol ausgebildet sein, welches durch unterschiedliche Schaltzustände der beiden Teilbereiche sichtbar gemacht werden kann.

In einer alternativen Ausgestaltung kann die Linie 7 auch beispielsweise von einer Seitenkante der elektrisch leitfähigen Schicht 3 zur gegenüberliegenden Seitenkante verlaufen, wodurch eine die Mehrschichtfolie 1 enthaltende Verglasung mit zwei Abschnitten versehen werden kann, deren optische Eigenschaften, insbesondere die Transmission von sichtbarem Licht, unabhängig voneinander schaltbar sind. Durch zwei Bediener kann so die Intensität des durch die Verglasung tretenden Lichts individuell gewählt werden. Durch eine Mehrzahl von Linien 7 ist auch die Ausbildung einer Mehrzahl von unabhängig voneinander schaltbaren Abschnitten möglich.

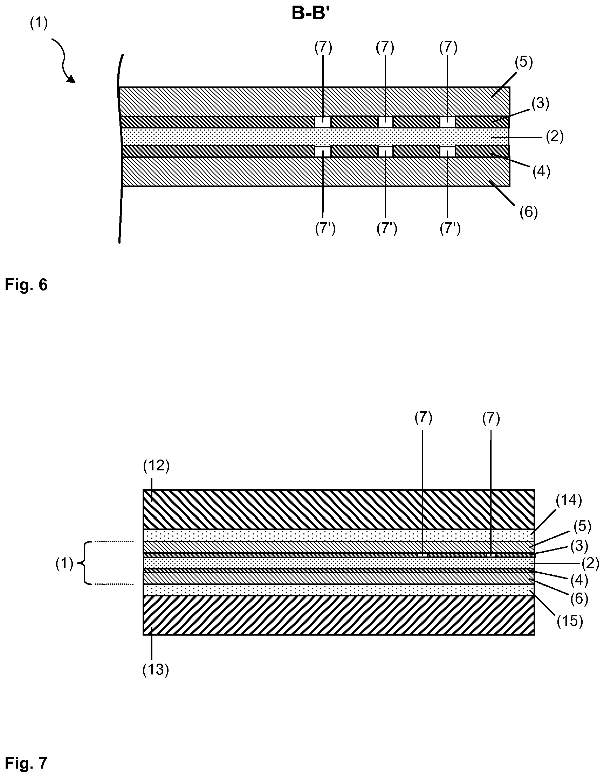

Fig. 5 und Fig. 6 zeigen je ein Detail einer weiteren Ausgestaltung der erfindungsgemäßen Mehrschichtfolie 1 mit elektrisch schaltbaren optischen Eigenschaften. Die elektrisch leitfähige Schicht 3 weist erfindungsgemäße elektrisch nicht leitfähige Linien 7 auf, welche die Form eines Gitters bilden. Das Gitter weist beispielsweise eine Breite von 10 cm und eine Länge von 5 cm auf. Benachbarte Gitterlinien weisen beispielsweise einen Abstand von 0,5 mm bis 15 mm auf. In der Zeichnung sind der Einfachheit halber deutlich weniger Gitterlinien dargestellt als in der Realität üblich. Die elektrisch leitfähige Schicht 4 weist ebenfalls elektrisch nicht leitfähige Linien 7' auf, welche genau wie die Linien 7 ausgebildet sind. Die Linien 7 und die Linien 7' sind deckungsgleich angeordnet. Das bedeutet, dass die Orthogonalprojektion der Linien 7 auf die elektrisch leitfähige Schicht 4 mit den Linien 7' zusammenfällt.

Die elektrisch leitfähigen Schichten 3, 4 an sich sind für Strahlung im Infrarot-, Mikrowellen- und Radiobereich nicht durchlässig. Durch die Linien 7, 7', welche die elektrisch leitfähigen Schichten 3, 4 unterbrechen, wird ein Bereich innerhalb der Mehrschichtfolie 1 erzeugt, durch den Strahlung im Infrarot-, Mikrowellen- und/oder Radiobereich transmittiert wird. Die Linien 7, 7' bilden ein sogenanntes Kommunikationsfenster aus, so dass beispielsweise GPS-, Radio und/oder Telekommunikationssignale durch eine mit der Mehrschichtfolie 1 versehene Verglasung hindurch treten können.

Fig. 7 zeigt einen Querschnitt durch die Mehrschichtfolie aus Fig. 2 und Fig. 3 eingelagert in der Zwischenschicht einer Verbundscheibe. Die Trägerfolie 5 ist über eine erste thermoplastische Verbindungsfolie 14 mit einer ersten Scheibe 12 verbunden. Die Trägerfolie 6 ist über eine zweite thermoplastische Verbindungsfolie 15 mit einer zweiten Scheibe 13 verbunden. Die thermoplastischen Verbindungsfolien 14, 15 bestehen beispielsweise aus Ethylenvinylacetat (EVA) und weisen jeweils eine Dicke von 0,38 mm auf. Die Scheiben 12, 13 bestehen beispielsweise aus Kalk-Natron-Glas und weisen Dicken von beispielsweise etwa 2 mm auf. Durch das Einlagern der Mehrschichtfolie 1 in die Zwischenschicht der Verbundscheibe kann auf einfache Weise eine Verbundscheibe mit elektrisch schaltbaren optischen Eigenschaften hergestellt werden. Die Verbindung der einzelnen Schichten zur Verbundscheibe erfolgt mittels herkömmlicher Verfahren unter Einwirkung von Temperatur, Druck und / oder Vakuum, wobei die Mehrschichtfolie 1 zwischen die thermoplastischen Verbindungsfolien 14, 15 eingelegt wird.

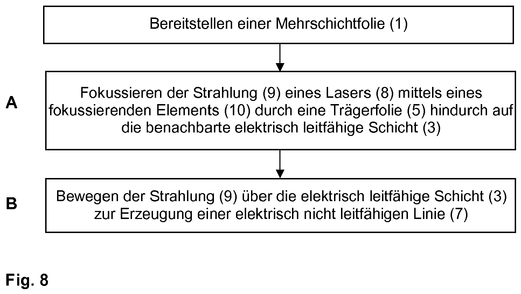

Fig. 8 zeigt ein Ausführungsbeispiel des erfindungsgemäßen Verfahrens zur Herstellung einer erfindungsgemäßen Mehrschichtfolie 1 mit elektrisch schaltbaren optischen Eigenschaften.

### Beispiele

Es wurden SPD-Funktionselemente als Mehrschichtfolien 1 nach Fig. 1 bereitgestellt. In die elektrisch leitfähige Schicht 3 der Mehrschichtfolien 1 wurden mittels des erfindungsgemäßen Verfahrens elektrisch nicht leitfähige Linien 7 eingebracht. Dazu wurde die Laserstrahlung 9 mittels einer f-theta-Linse mit einer Brennweite von 20 cm auf die elektrisch leitfähige Schicht 3 fokussiert und über die elektrisch leitfähige Schicht 3 bewegt. Das Verfahren wurde mit Laserstrahlung 9 zweier verschiedener Wellenlängen durchgeführt. Als Laser 8 wurde jeweils ein gepulst betriebener Nd-YAG-Laser mit einer Emissionswellenlänge von 1064 nm verwendet. Im Beispiel 1 wurde durch einfache Frequenzverdopplung eine Wellenlänge von 532 nm erzeugt. Im Beispiel 2 wurde durch zweifache Frequenzverdopplung eine Wellenlänge von 355 nm erzeugt. Die Werte für die Wellenlänge λ, die Pulsdauer τ, die Pulsfolgefrequenz f, die Bewegungsgeschwindigkeit v und die Leistung P der Laserstrahlung 9, der Durchmesser d des Strahlungsfokus sowie die Absorption A₃(λ) der ersten elektrisch leitfähigen Schicht 3 und die Absorption A₅(λ) der ersten Trägerfolie 5 bei der jeweiligen Wellenlänge λ sind in Tabelle 1 angegeben.

**Tabelle 1**

| | λ / nm | T / ns | f / kHz | v / mm/s | P /W | d / µm | A₃(λ) / % | A₅(λ) / % |
|---|---|---|---|---|---|---|---|---|
| Beispiel 1 | 532 | 10 | 30 | 500 | 10 | 100 | 0,4 | 0,7 |
| Beispiel 2 | 355 | 16 | 60 | 1000 | 0,3 | 40 | 12,6 | 5,7 |

Sowohl im Beispiel 1 als auch im Beispiel 2 konnten die Linien 7 selektiv in die elektrisch leitfähige Schicht 3 eingebracht werden, ohne die Trägerfolie 5 zu beschädigen. Dieses Ergebnis war für den Fachmann unerwartet und überraschend.

Im Beispiel 1 wiesen die Linien 7 geringe Linienbreiten auf, die für den Betrachter nur wenig sichtbar waren. Die Linienbreite betrug etwa 100 µm. Die aktive Schicht 2 wies eine leichte Verfärbung auf, die Funktionalität der aktiven Schicht 2 wurde jedoch nicht beeinträchtigt. Im Beispiel 2 war die Linienbreite der Linien 7 noch geringer als im Beispiel 1 aufgrund des geringeren Durchmessers d. Die Linienbreite betrug etwa 40 µm. Die Verfärbung der aktiven Schicht 2 war noch weniger stark ausgeprägt. Der Grund hierfür war insbesondere die höhere Absorption A₃(λ), welche eine geringe Leistungsdichte der Laserstrahlung 9 (2,5^{∗}10⁷ W/cm² im Beispiel 2 gegenüber 4,5^{∗}10⁸ W/cm² im Beispiel 1) zur effektiven Laserstrukturierung erforderlich machte. Wie dem Fachmann bekannt ist, kann die Leistungsdichte als P/(π f τ (d/2)²) berechnet werden. Die Linien 7 waren insgesamt im Beispiel 2 für den Betrachter noch weniger auffällig als im Beispiel 1.

Mittels der elektrisch nicht leitfähigen Linien 7 konnte die elektrisch leitfähige Schicht 3 in elektrisch nicht miteinander verbundene Teilbereiche aufgeteilt werden. In die elektrisch leitfähige Schicht 4 wurden keine Strukturierungslinien eingebracht. Es konnten so Teilbereiche der Mehrschichtfolie 1 realisiert werden, deren optische Eigenschaften unabhängig voneinander schaltbar waren. Es war für den Fachmann unerwartet und überraschend, dass durch dünne Linien 7 in nur einer der elektrisch leitfähigen Schichten 3, 4 solche unabhängig voneinander schaltbaren Teilbereiche realisiert werden konnten, ohne dass sich das elektrische Feld über die Linien 7 hinweg ausbreitete.

### Bezugszeichenliste:

- (1): Mehrschichtfolie mit elektrisch schaltbaren optischen Eigenschaften
- (2): aktive Schicht der Mehrschichtfolie 1
- (3): elektrisch leitfähige Schicht der Mehrschichtfolie 1
- (4): elektrisch leitfähige Schicht der Mehrschichtfolie 1
- (5): Trägerfolie der Mehrschichtfolie 1
- (6): Trägerfolie des der Mehrschichtfolie 1
- (7): elektrisch nicht leitfähige Linie der elektrisch leitfähigen Schicht 3
- (7'): elektrisch nicht leitfähige Linie der elektrisch leitfähigen Schicht 4
- (8): Laser
- (9): Strahlung des Lasers 8
- (10): fokussierendes Element
- (11): verkippbarer Spiegel
- (12): Scheibe
- (13): Scheibe
- (14): thermoplastische Verbindungsfolie
- (15): thermoplastische Verbindungsfolie
- x: Bewegungsrichtung der Strahlung 9
- x₀, x₁: Positionen der Strahlung 9 während des erfindungsgemäßen Verfahrens
- A-A': Schnittlinie
- B-B': Schnittlinie

## Patentansprüche

1. Mehrschichtfolie (1) mit elektrisch schaltbaren optischen Eigenschaften, mindestens umfassend in der Reihenfolge flächenmäßig angeordnet:
a) eine erste Trägerfolie (5),
b) eine elektrisch leitfähige Schicht (3),
c) eine aktive Schicht (2),
d) eine elektrisch leitfähige Schicht (4) und
e) eine zweite Trägerfolie (6), wobei zumindest eine elektrisch leitfähige Schicht (3, 4) mindestens eine elektrisch nicht leitfähige Linie (7) aufweist, welche mit einem Laser (8) durch eine der beiden Trägerfolien (5, 6) hindurch in die elektrisch leitfähige Schicht (3, 4) eingebracht ist, wobei die elektrisch nicht leitfähige Linie (7) nach dem Verbinden der Trägerfolien (5, 6), der elektrisch leitfähigen Schichten (3,4) und der aktiven Schicht (2) zur Mehrschichtfolie (1) in die elektrisch leitfähige Schicht (3, 4) eingebracht ist, wobei die Trägerfolie keine Unterbrechung aufweist,
wobei die Linie (7) die elektrisch leitfähige Schicht (3, 4) in mindestens zwei Teilbereiche aufteilt, welche nicht elektrisch leitend miteinander verbunden sind, und **dadurch gekennzeichnet, dass**
i) die Linie (7) als geschlossene Form ohne Enden ausgestaltet ist, oder
ii) jeder Teilbereich dafür vorgesehen ist, mit einer von mindestens zwei unabhängigen Spannungsquellen verbunden zu werden und somit als Flächenelektrode dient.

2. Mehrschichtfolie (1) nach Anspruch 1, die ein SPD-, ein PDLC- oder ein elektrochromes Funktionselement ist, bevorzugt ein SPD-Funktionselement.

3. Mehrschichtfolie (1) nach einem der Ansprüche 1 bis 2, wobei die Linie (7) durch die benachbarte Trägerfolie (5, 6) hindurch in die elektrisch leitfähige Schicht (3, 4) eingebracht ist.

4. Mehrschichtfolie (1) nach einem der Ansprüche 1 bis 3, wobei die Linienbreite der Linie (7) kleiner oder gleich 500 µm beträgt, bevorzugt von 10 µm bis 150 µm, besonders bevorzugt von 20 µm bis 50 µm.

5. Mehrschichtfolie nach einem der Ansprüche 1 bis 4, wobei beide elektrisch leitfähigen Schichten (3, 4) mindestens eine Linie (7, 7') aufweisen und wobei die Linien (7, 7') zumindest teilweise deckungsgleich angeordnet sind.

6. Mehrschichtfolie (1) nach einem der Ansprüche 1 bis 5, wobei die Trägerfolien (5, 6) zumindest ein thermoplastisches Polymer enthalten, bevorzugt Polyethylenterephthalat, Ethylenvinylacetat und / oder Polyvinylbutyral.

7. Mehrschichtfolie (1) nach einem der Ansprüche 1 bis 6, wobei die elektrisch leitfähigen Schichten (3, 4) zumindest ein Metall, eine Metalllegierung oder ein transparentes leitfähiges Oxid enthalten, bevorzugt ein transparentes leitfähiges Oxid.

8. Mehrschichtfolie (1) nach einem der Ansprüche 1 bis 7, wobei die elektrisch leitfähigen Schichten (3, 4) eine Dicke von 10 nm bis 2 µm aufweisen.

9. Verbundscheibe mit einer Mehrschichtfolie (1) nach einem der Ansprüche 1 bis 8, wobei die Mehrschichtfolie (1) zwischen mindestens zwei Scheiben (12, 13) angeordnet ist und bevorzugt mit jeder Scheibe (12, 13) über zumindest eine thermoplastische Verbindungsfolie (14, 15) verbunden ist.

10. Verfahren zur Herstellung einer Mehrschichtfolie (1) mit elektrisch schaltbaren optischen Eigenschaften nach einem der Ansprüche 1 bis 8, wobei bei einer Mehrschichtfolie (1) zumindest
A) die Strahlung (9) eines Lasers (8) durch eine Trägerfolie (5, 6) hindurch auf eine elektrisch leitfähige Schicht (3, 4) fokussiert wird und
B) die Strahlung (9) über die elektrisch leitfähige Schicht (3, 4) bewegt wird und dabei mindestens eine elektrisch nicht leitfähige Linie (7) in die elektrisch leitfähige Schicht (3, 4) eingebracht wird.

11. Verfahren nach Anspruch 10, wobei die elektrisch leitfähige Schicht (3, 4) eine Absorption bei der Wellenlänge der Strahlung (9) von größer oder gleich 0,1%, bevorzugt von größer oder gleich 0,3% aufweist und wobei die Trägerfolie (5, 6) eine Absorption bei der Wellenlänge der Strahlung (9) von kleiner oder gleich 15%, bevorzugt von kleiner oder gleich 10% aufweist und wobei bevorzugt das Verhältnis der Absorption der elektrisch leitfähigen Schicht (3, 4) zur Absorption der Trägerschicht (5, 6) bei der Wellenlänge der Strahlung (9) größer oder gleich 0,5, bevorzugt größer oder gleich 1 beträgt.

12. Verfahren nach Anspruch 10 oder 11, wobei die Wellenlänge der Strahlung (9) von 150 nm bis 1200 nm, bevorzugt von 200 nm bis 500 nm, besonders bevorzugt von 250 nm bis 400 nm beträgt.

13. Verfahren nach einem der Ansprüche 10 bis 12, wobei die Strahlung (9) mit einer Geschwindigkeit von 100 mm/s bis 10000 mm/s, bevorzugt von 200 mm/s bis 5000 mm/s bewegt wird.

14. Verfahren nach einem der Ansprüche 10 bis 13, wobei der Laser (8) gepulst betrieben wird und die Pulslänge bevorzugt kleiner oder gleich 50 ns beträgt und die Pulsfolgefrequenz bevorzugt von 1 kHz bis 200 kHz beträgt.

15. Verwendung einer Mehrschichtfolie (1) nach einem der Ansprüche 1 bis 8 in Verglasungen, insbesondere in Verbundscheiben, in Gebäuden, insbesondere im Zugangs- oder Fensterbereich, oder in Fortbewegungsmitteln für den Verkehr auf dem Lande, in der Luft oder zu Wasser, insbesondere in Zügen, Schiffen, Flugzeugen und Kraftfahrzeugen, beispielsweise als Heckscheibe, Seitenscheibe und / oder Dachscheibe.

## Claims

1. Multi-layered film (1) having electrically switchable optical properties, at least comprising in this order and arranged in a planar manner:
a) a first carrier film (5),
b) an electrically conductive layer (3),
c) an active layer (2),
d) an electrically conductive layer (4) and
e) a second carrier film (6),
wherein at least one electrically conductive layer (3, 4) has at least one electrically non-conductive line (7) which is introduced in the electrically conductive layer (3, 4) through one of the two carrier films (5, 6) by a laser (8), wherein the electrically non-conductive line (7) after the connection of the carrier films (5, 6), the electrically conductive layers (3, 49 and the active layer (2) to the multi-layered film (1), is introduced in the electrically conductive layer (3, 4), wherein the carrier film has no interruption, wherein the line (7) divides the electrically conductive layer (3, 4) into at least two portions which are not electrically conductively connected to each other, and **characterized in that**
i) the line (7) is configured as closed form without ends, or
ii) each portion is envisaged to be connected to one of at least two independent voltage sources and thus serves as planar electrode.

2. Multi-layered film (1) according to claim 1, which is an SPD, a PDLC or an electrochromic functional element, preferably an SPD functional element.

3. Multi-layered film (1) according to one of claims 1 through 2, wherein the line (7) is introduced in the electrically conductive layer (3, 4) through the adjacent carrier film (5, 6).

4. Multi-layered film (1) according to one of claims 1 through 3, wherein the line width of the line (7) is smaller or equal to 500 µm, preferably from 10 µm to 150 µm, particularly preferably from 20 µm to 50 µm.

5. Multi-layered film (1) according to one of claims 1 through 4, wherein both electrically conductive layers (3, 4) respectively have at least one line (7, 7') and wherein the lines (7, 7') are arranged at least partially in registration.

6. Multi-layered film (1) according to one of claims 1 through 5, wherein the carrier films (5, 6) include at least one thermoplastic polymer, preferably polyethylene terephthalate, ethylene vinyl acetate and/or polyvinyl butyral.

7. Multi-layered film (1) according to one of claims 1 through 6, wherein the electrically conductive layers (3, 4) include at least one metal, a metal alloy or a transparent conductive oxide, preferably a transparent conductive oxide.

8. Multi-layered film (1) according to one of claims 1 through 7, wherein the electrically conductive layers (3, 4) have a thickness of 10 nm to 2 µm.

9. Composite pane with a multi-layered film (1) according to one of claims 1 through 8, wherein the multi-layered film (1) is arranged between at least two panes (12, 13) and is preferably connected with each pane (12, 13) by at least one thermoplastic connection film (14, 15).

10. Process for the production of a multi-layered film (1) with electrically switchable optical properties according to one of claims 1 through 8, wherein with a multi-layered film (1) at least
A) the radiation (9) of a laser (8) is focused on an electrically conductive layer (3, 4) through a carrier film (5, 6) and
B) the radiation (9) is moved over the electrically conductive layer (3, 4) to thereby introduce at least one electrically non-conductive line (7) in the electrically conductive layer (3, 4).

11. Process according to claim 10, wherein the electrically conductive coating (3, 4) has an absorption at the wavelength of the radiation (9) of bigger than or equal to 0.1 %, preferably of bigger than or equal to 0.3 %, and wherein the carrier film (5, 6) has an absorption at the wavelength of the radiation (9) of smaller than or equal to 15 %, preferably of smaller than or equal to 10 %, and wherein preferably the ratio of the absorption of the electrically conductive layer (3, 4) to the absorption of the carrier film (5, 6) at the wavelength of the radiation (9) is bigger than or equal to 0.5, preferably bigger than or equal to 1.

12. Process according to claim 10 or 11, wherein the wavelength of the radiation (9) is from 150 nm to 1200 nm, preferably from 200 nm to 500 nm, and particularly preferably from 250 nm to 400 nm.

13. Process according to one of claims 10 through 12, wherein the radiation (9) is moved with a velocity of 100 mm/sec to 10000 mm/sec, preferably from 200 mm/sec to 5000 mm/sec.

14. Process according to one of claims 10 through 13, wherein the laser (8) is operated in a pulsed manner and the length of the pulses is preferably smaller than or equal to 50 ns and the frequency of the pulses is preferably from 1 kHz to 200 kHz.

15. Use of a multi-layered film (1) according to one of the claims 1 through 8 in glazings, in particular in composite panes, in buildings, in particular in the entry or window area, or in means for moving for traffic on land, in air or in water, in particular in trains, ships, planes and vehicles, for example as rear pane, side pane and/or roof pane.

## Revendications

1. Film multicouche (1) avec des propriétés optiques électriquement commutables, comprenant au moins dans l'ordre disposés à la surface :
a) un premier film de support (5);
b) une couche conductrice d'électricité (3);
c) une couche active (2);
d) une couche conductrice d'électricité (4) et
e) un deuxième film de support (6);
où au moins une couche conductrice d'électricité (3, 4) présente au moins une ligne (7) non conductrice d'électricité, qui est introduite avec un laser (8) à travers l'un des deux films de support (5, 6) dans la couche électriquement conductrice (3, 4), où la ligne électrique non conductrice (7) après jonction des films de support (5, 6), des couches conductrices électriques (3,4) et de la couche active (2) pour former le film multicouche (1) est introduite dans la couche conductrice électrique (3, 4), où le film de support ne présente aucune rupture, où la ligne (7) divise la couche conductrice électrique (3, 4) en au moins deux sous-zones, qui ne sont pas électriquement connectées l'une à l'autre, et **caractérisée en ce que**
(i) la ligne (7) est conçue comme une forme fermée sans extrémités
(ii) chaque sous-zone est conçue pour être reliée à l'une d'au moins deux sources de tension indépendantes et sert ainsi d'électrode de surface.

2. Film multicouche (1) selon la revendication 1, qui est un élément fonctionnel SPD, PDLC ou électrochrome, de préférence un élément fonctionnel SPD.

3. Film multicouche (1) selon l'une des revendications 1 à 2, où la ligne (7) est introduite dans la couche conductrice électrique (3, 4)à travers le film de support adjacent (5, 6).

4. Film multicouche (1) selon l'une des revendications 1 à 3, où la largeur de la ligne (7) est inférieure ou égale à 500 µm, de préférence de 10 µm à 150 µm, de manière particulièrement préférée de 20 µm à 50 µm.

5. Film multicouche selon l'une des revendications 1 à 4, où les deux couches conductrices d'électricité (3, 4) ont au moins une ligne (7, 7') et où les lignes (7, 7') sont disposées de manière à se recouvrir au moins partiellement.

6. Film multicouche (1) selon l'une des revendications 1 à 5, où les films de support (5, 6) contiennent au moins un polymère thermoplastique, de préférence du polyéthylène téréphtalate, de l'éthylène-acétate de vinyle et/ou du polyvinyle de butyral.

7. Film multicouche (1) selon l'une des revendications 1 à 6, où les couches conductrices d'électricité (3, 4) contiennent au moins un métal, un alliage métallique ou un oxyde conducteur transparent, de préférence un oxyde conducteur transparent.

8. Film multicouche (1) selon l'une des revendications 1 à 7, où les couches conductrices d'électricité (3, 4) ont une épaisseur de 10 nm à 2 µm.

9. Vitre feuilletée avec un film multicouche (1) selon l'une des revendications 1 à 8, où le film multicouche (1) est disposé entre au moins deux plaques (12, 13) et de préférence est reliée à chaque plaque (12, 13) par au moins un film de connexion thermoplastique (14, 15).

10. Procédé de fabrication d'un film multicouche (1) avec des propriétés optiques électriquement commutables selon l'une des revendications 1 à 8, où dans un film multicouches (1) au moins
A) le rayonnement (9) d'un laser (8) est focalisé à travers un film de support (5, 6) sur une couche conductrice d'électricité (3, 4) et
B) le rayonnement (9) est déplacé sur la couche conductrice d'électricité (3, 4) et au moins une ligne électrique non conductrice (7) est introduite dans la couche conductrice électrique (3, 4).

11. Procédé selon la revendication 10, où la couche conductrice d'électricité (3, 4) présente une absorption à la longueur d'onde du rayonnement (9) supérieure ou égale à 0,1%, de préférence supérieure ou égale à 0,3% et où le film de support (5, 6) présente une absorption à la longueur d'onde du rayonnement (9) inférieure ou égale à 15%, de préférence inférieure ou égale à 10% et où de préférence le rapport d'absorption de la couche conductrice d'électricité (3, 4) à l'absorption de la couche de support (5, 6) à la longueur d'onde du rayonnement (9) est supérieur ou égal à 0,5, de préférence supérieur ou égal à 1.

12. Procédé selon la revendication 10 ou 11, où la longueur d'onde du rayonnement (9) est de 150 nm à 1200 nm, de préférence de 200 nm à 500 nm, de préférence de 250 nm à 400 nm.

13. Procédé selon l'une des revendications 10 à 12, où le rayonnement (9) est déplacé à une vitesse de 100 mm/s à 10000 mm/s, de préférence de 200 mm/s à 5000 mm/s.

14. Procédé selon l'une des revendications 10 à 13, où le laser (8) fonctionne en mode pulsé et la longueur d'impulsion est de préférence inférieure ou égale à 50 ns et la fréquence de répétition des impulsions est de préférence de 1 kHz à 200 kHz.

15. L'utilisation d'un film multicouche (1) selon l'une des revendications 1 à 8 dans les vitrages, en particulier dans les vitres composites, dans les bâtiments, en particulier dans les zones d'accès ou des fenêtres, ou dans des moyens de locomotion sur la terre, dans l'air ou sur l'eau, en particulier dans les trains, les navires, les avions et les véhicules à moteur, par exemple comme lunette arrière, vitre latérale et/ ou fenêtre de toit.
